# EUROPÄISCHE PATENTSCHRIFT

(11) **EP 1 596 213 B1**
(45) Veröffentlichungstag und Bekanntmachung des Hinweises auf die Patenterteilung: **10.10.2007**
(21) Anmeldenummer: 05016523.2
(22) Anmeldetag: 11.05.2000
(51) Int. Cl.: G01R 31/36

(54) **Elektronische Überwachungseinrichtung für mehrteiligen elektrischen Energiespeicher**
Electronic monitoring device for multi-part electric energy storage unit
Appareil électronique de surveillance pour accumulateur d'énergie électrique à plusieurs parties

(30) Priorität: 11.05.1999 DE 19921675
(43) Veröffentlichungstag der Anmeldung: 16.11.2005
(62) Teilanmeldung aus: 00931193.7
(73) Patentinhaber: DaimlerChrysler AG, 70327 Stuttgart (DE)
(72) Erfinder: Bulling, Markus, 88400 Biberach (DE); Walter, Markus, 72581 Dettingen (DE); Hornung, Hans-Georg, 86875 Waal (DE)

(56) Entgegenhaltungen:
- US-A- 5 099 211
- US-A- 5 578 927
- US-A- 5 760 587

## Beschreibung

Die Erfindung bezieht sich auf eine elektronische Überwachungseinrichtung für einen aus mehreren hintereinander geschalteten Speichereinheiten bestehenden elektrischen Energiespeicher, insbesondere für eine Mehrzellen- oder Mehrblock-Batterie, wobei die Überwachungseinrichtung eine entsprechende Anzahl von Messmodulen beinhaltet, die jeweils einer der Speichereinheiten zugeordnet sind und wenigstens eine speicherzustandsindikative Messgröße an der zugeordneten Speichereinheit messen. Der Einfachkeit halber sollen vorliegend unter dem Begriff "elektrischer Energiespeicher" neben bloßen Speichern, wie Batterien, auch Energieerzeuger verstanden werden, die aus nicht-elektrischer, gespeicherter Energie, z.B. mechanischer oder chemischer Energie, elektrische Energie erzeugen, z.B. Brennstoffzellensysteme

Aus der nächstliegenden US 5,760,587 A1 ist eine elektronische Überwachungseinrichtung für einen aus mehreren hintereinandergeschalteten Speichereinheiten bestehenden elektrischen Energiespeicher bekannt. Den Speichereinheiten sind jeweils Messmodule zugeordnet, die ihrerseits parallel an eine gemeinsame Signalverbindung (SV') angeschlossen sind und die wenigstens eine speicherzustandsindikative Messgröße an der zugeordneten Speichereinheit messen.

Derartige Überwachungseinrichtungen dienen zur Überwachung des Zustands der einzelnen Blöcke oder Zellen des elektrischen Energiespeichers, wie einer Traktionsbatterie eines Kraftfahrzeugs mit Elektro- oder Hybridantrieb oder eines Brennstoffzellenstapels z.B. in einem Brennstoffzellenfahrzeug. Typische überwachte, für den Speicherzustand indikative Messgrößen sind insbesondere die von der jeweiligen Speichereinheit bereitgestellte elektrische Spannung sowie die Temperatur und der Druck in der Speichereinheit. Die Überwachung dient unter anderem der Feststellung unterschiedlicher Ladezustände der Speichereinheiten aufgrund ungleichmäßiger Selbstentladung und Alterung der seriell geschalteten Speichereinheiten, so dass gegebenenfalls geeignete Gegenmaßnahmen ergriffen werden können, z.B. ein Ladungstransfer zwischen Speichereinheiten, um deren Ladezustand auf annähernd gleichem Niveau zu halten und so zu vermeiden, dass die Gesamtkapazität des elektrischen Energiespeichers von der "schlechtesten" Speichereinheit bestimmt wird.

Eine Überwachungseinrichtung der eingangs genannten Art ist in der Patentschrift DE 195 03 917 C2 beschrieben. Bei der dortigen Einrichtung sind die einzelnen Messmodule an einen als Ring ausgelegten, seriellen Datenbus angeschlossen, an den auch eine zentrale Datenverarbeitungseinheit angekoppelt ist. Die Messdateninformationen werden von Messmodul zu Messmodul in Form von Messdatenpaketen über den Ring geleitet, wobei jedes Messmodul von jedem Messdatenpaket die von ihm benötigten Informationen entnimmt und dem Messdatenpaket seine eigenen Messdaten, z.B. über Spannung und Temperatur der zugehörigen Speichereinheit, hinzufügt. Die zentrale Datenverarbeitungseinheit kann die Messdaten zur Bestimmung des Zustands der einzelnen Speichereinheiten und damit des gesamten elektrischen Energiespeichers auswerten.

Bei einem weiteren Typ gattungsgemäßer Batterieüberwachungseinrichtungen sind die den einzelnen Speichereinheiten zugeordneten Messmodule parallel an eine gemeinsame Signalverbindung angekoppelt. Bei einer in der Offenlegungsschrift EP 0 277 321 A1 beschriebenen derartigen Einrichtung übertragen die Messmodule nacheinander nach Aufruf ihre Messdaten zu einer zentralen Auswerteeinheit.

Der Erfindung liegt als technisches Problem die Bereitstellung einer elektronischen Überwachungseinrichtung der eingangs genannten Art zugrunde, die vergleichsweise wenig Verkabelungs- und Steuerungsaufwand erfordert und zuverlässige Aussagen über den Zustand des Energiespeichers anhand der Erfassung einer oder mehrerer entsprechender Messgrößen ermöglicht.

Die Erfindung löst dieses Problem durch die Bereitstellung einer elektronischen Überwachungseinrichtung mit den Merkmalen des Anspruchs 1. Die erfindungsgemäße Überwachungseinrichtung erfordert relativ wenig Verkabelungsaufwand und erlaubt mindestens die Bestimmung von im allgemeinen besonders interessierenden, für den Zustand des elektrischen Energiespeichers indikativen Extremalwerten des oder der verwendeten Messgrößen.

Die Überwachungseinrichtung nach Anspruch 1 zeichnet sich speziell dadurch aus, dass die Messmodule parallel an eine gemeinsame Signalverbindung angekoppelt sind und ihre Meßgrößeninformationen dergestalt konditionieren und parallel auf die Signalleitung geben, dass die dadurch auf dieser gebildete Gesamt-Messgrößeninformation eine auswertbare, zugehörige Extremalwert-Messgrößeninformation enthält. Diese Einrichtung erfordert keine separaten Signalverbindungen zwischen je zwei Messmodulen und keine separaten Bewertungsvorgänge in den Messmodulen. Vielmehr erfolgt die Bewertung automatisch durch die Überlagerung der Messgrößeninformationen der verschiedenen Messmodule auf der gemeinsamen Signalleitung. Die Messmodule können ohne Laufzeitfehler gleichzeitig getriggert werden. In weiterer Ausgestaltung dieser Variante sind die Messmodule gemäß Anspruch 2 über eine Kapazität oder Induktivität und damit galvanisch entkoppelt an die gemeinsame Signalleitung angeschlossen.

In einer Weiterbildung der Erfindung nach Anspruch 3 sind die Messmodule durch Betriebsmodus-Steuersignale zwischen einem aktivierten und einem deaktivierten Zustand umschaltbar, wobei ihr Stromverbrauch im deaktivierten Zustand minimiert ist. Die Steuersignale können je nach Systemvariante den Messmodulen auf einer gemeinsamen Signalleitung parallel zugeführt oder sequentiell von einem zum nächsten Messmodul weitergereicht werden. Mit Hilfe dieser Betriebsmodus-Steuersignale können die momentan jeweils nicht benötigten Messmodule energiesparend im deaktivierten Zustand gehalten werden.

In einer Weiterbildung der Erfindung nach Anspruch 4 sind die Messmodule durch Bewertungsmodus-Steuersignale zwischen verschiedenen Bewertungsmodi umschaltbar, z.B. zwischen einer Bewertung hinsichtlich Maximum oder Minimum einer jeweiligen Messgröße oder zwischen Bewertungen unterschiedlicher Messgrößen. Dadurch können diese verschiedenen Messgrößeninformationen zu unterschiedlichen Zeiten auf derselben Signalleitung bereitgestellt werden.

In einer Weiterbildung der Erfindung nach Anspruch 5 können die Messmodule selektiv in aktive und passive Messmodule unterteilt werden, wobei unter aktiven Messmodulen solche mit voll aktiviertem Funktionsumfang und unter passiven Messmodulen solche zu verstehen sind, die so weit in Bereitschaft gehalten sind, dass sie empfangene Signale weiterleiten können, z.B. die von einem benachbarten Messmodul übertragene Messgrößeninformation, jedoch keine Änderung solcher bloß weitergeleiteter Signale aufgrund eigener Messwerte vornehmen. Damit lassen sich bei der Systemvariante mit sequentieller Weiterleitung und Bewertung der Messgrößeninformation beliebige Messmodule auswählen, die an der Gewinnung der bewerteten Messgrößeninformation aktiv teilnehmen.

In einer Weiterbildung der Erfindung nach Anspruch 6 wird das Messsignal in Form eines pulsweitenmodulierten Signals, dessen Pulsbreite den zugehörigen Messgrößenwert repräsentiert, von den Messmodulen abgegeben. Dies ermöglicht sehr einfache Extremalwertbestimmungen im Rahmen eines entsprechenden Extremalwert-Bewertungskriteriums und vermeidet Fehleradditionen bei einem seriellen Weiterreichen der Messgrößeninformation von Messmodul zu Messmodul. Alternativ ist in einer Weiterbildung der Erfindung nach Anspruch 7 eine Messsignalkonditionierung dergestalt vorgesehen, dass das jeweilige Messsignal aus einem Puls besteht, der um eine vom jeweiligen Messwert abhängige Zeitspanne verzögert gesendet wird. Auch dieser Messsignaltyp erlaubt sehr einfache Extremalwertbestimmungen. Weiter alternativ ist in einer Weiterbildung der Erfindung nach Anspruch 8 das Messsignal als ein Konstantstromsignal konditioniert, das ebenfalls eine einfache Extremalwertbestimmung ermöglicht.

In einer weiteren Ausgestaltung der Erfindung ermöglicht die Überwachungseinrichtung gemäß Anspruch 9 eine dissipative Ladezustandsangleichung, indem die Messmodule jeweils einen elektrischen Widerstand enthalten, über den Speichereinheiten mit zu hohem detektiertem Ladezustand so weit entladen werden können, dass der maximale Ladezustandsunterschied zwischen den Speichereinheiten einen vorgebbaren Toleranzwert nicht überschreitet.

Bevorzugte Ausführungsformen der Erfindung werden nachfolgend unter Bezugnahme auf die Zeichnungen beschrieben, in denen zeigen:
- Fig. 1: ein Blockschaltbild einer mehrzelligen Batterie mit zugeordneter elektronischer Überwachungseinrichtung mit seriell verschalteten Messmodulen,
- Fig. 2: eine schematische Darstellung von Triggersignalen und Spannungsmesssignalen zur Erläuterung der Betriebsweise der Überwachungseinrichtung von Fig. 1 und
- Fig. 3: eine Darstellung entsprechend Fig. 1, jedoch für eine Variante mit parallel verschalteten Messmodulen.

Wie in der Stammanmeldung EP 1 127 280 ausgeführt, kann die Schaltung auch in Form von seriell hintereinandergeschalteten Einzelzellen realisiert werden. Die sich damit ergebenden Vorteile können wie weiter unter ausgeführt mit der erfindungsgemäßen parallelen Verschaltung analog erzielt und/oder ergänzt werden.

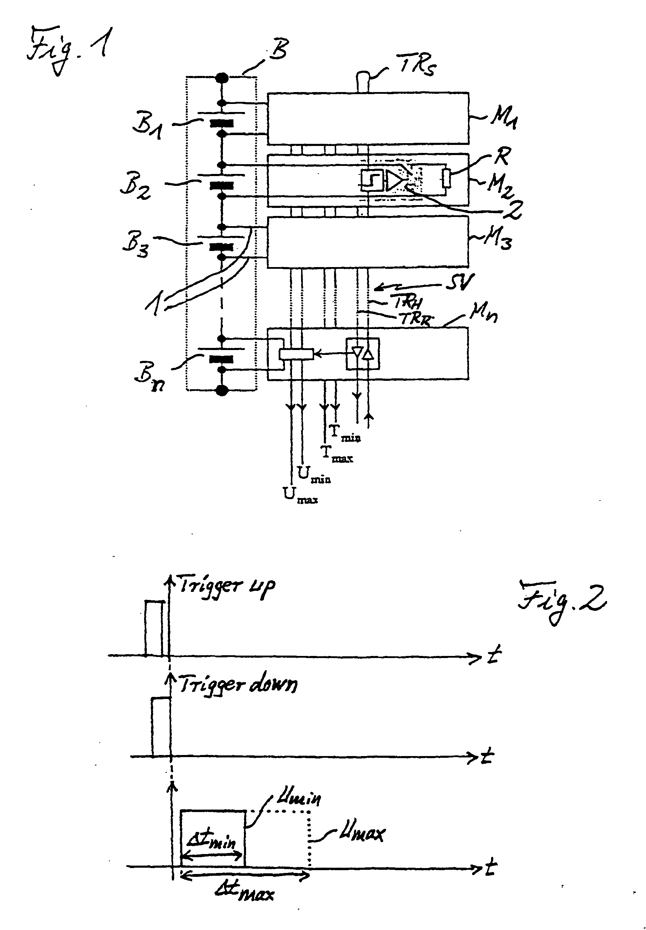

Fig. 1 zeigt schematisch eine aus mehreren, seriell hintereinandergeschalteten Einzelzellen B₁, B₂, ..., Bₙ bestehende Batterie B, die beispielsweise als Traktionsbatterie in einem Elektrofahrzeug oder einem Fahrzeug mit Hybridantrieb dienen kann. Jeder Batteriezelle B₁, ..., Bₙ ist ein Messmodul M₁, ..., Mₙ zugeordnet. Jedes Messmodul M₁, ..., Mₙ sensiert einen oder mehrere, für den Speicherzustand seiner zugeordneten Batteriezelle indikative Messgrößen, wie Spannung, Temperatur und Druck, wozu es über entsprechende Messleitungen 1 mit diesem verbunden ist.

Die Messmodule M₁, ..., Mₙ sind untereinander über eine serielle Signalverbindung SV miteinander verbunden, wobei die serielle Signalverbindung SV im gezeigten Beispiel ein Triggerleitungspaar TR_{H}, TR_{R}, ein Spannungssignalleitungspaar SPₘᵢₙ, SPₘₐₓ und ein Temperatursignalleitungspaar TEₘᵢₙ, TEₘₐₓ umfasst. Das Triggerleitungspaar besteht aus einer Triggersignal-Hinleitung TR_{H}, über die ein Triggersignal sukzessive vom letzten Messmodul Mₙ bis zum ersten Messmodul M₁ geleitet wird, und einer Triggersignal-Rückleitung TR_{R}, die am ersten Messmodul M₁ mit der Hinleitung TR_{H} verbunden ist, wie mit einer Leitungsschleife TR_{S} symbolisiert, und von dort bis zum letzten Messmodul Mₙ zurückführt. An das Triggerleitungspaar TR_{H}, TR_{R} ist in jedem Messmodul M₁, ..., Mₙ eine zugehörige Triggerschaltung herkömmlicher Art angekoppelt, die bei Empfang eines entsprechenden Triggersignals das Messmodul dazu aktiviert, einen Mess- und Bewertungsvorgang durchzuführen.

Im gezeigten Beispiel sind die Messmodule M₁, ...,Mₙ, zur Durchführung der Mess- und Bewertungsvorgänge derart ausgelegt, dass der Maximalwert und der Minimalwert der Spannungen und der Temperaturen der einzelnen Batteriezellen B₁. ..., Bₙ ermittelt werden können. Die auf diese Weise ermittelten vier Extremalwerte stehen auf den entsprechenden Signalleitungen am zugehörigen Ausgang des ersten Messmoduls M₁ an, d.h. der minimale Spannungswert Uₘᵢₙ an der Spannungssignalleitung SPₘᵢₙ, der maximale Spannungswert Uₘₐₓ auf der Spannungssignalleitung SPₘₐₓ, der minimale Temperaturwert Tₘᵢₙ auf der Temperatursignalleitung TEₘᵢₙ und der maximale Temperaturwert Tₘₐₓ auf der Temperatursignalleitung TEₘₐₓ. In alternativen Systemauslegungen kann die Bestimmung nur eines Teils dieser vier Extremalwerte und/oder die zusätzliche Ermittlung entsprechender Extremalwerte für den Druck in der jeweiligen Batteriezelle vorgesehen sein. Je nach den verwendeten Bewertungskriterien können statt oder zusätzlich zu solchen Extremalwerten auch andere, für den Speicherzustand der einzelnen Batteriezellen B₁, ..., Bₙ indikative Parameter über die Messmodulkette M₁, ..., Mₙ überwacht, d.h. von den Messmodulen M₁, ..., Mₙ entsprechende Messgrößeninformationen geliefert werden.

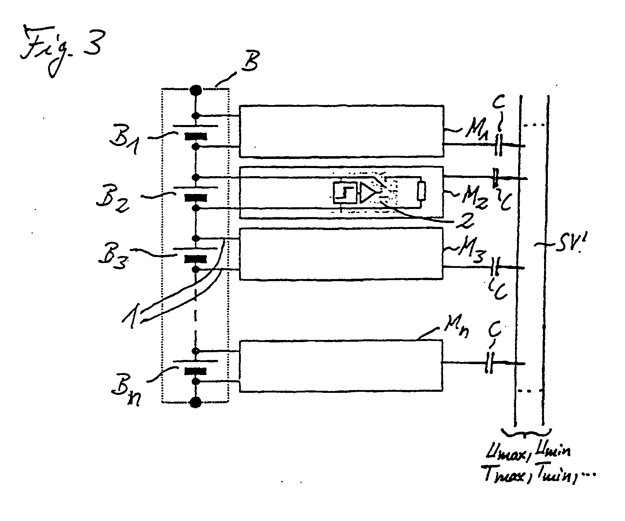

Die Ermittlung der Extremalwerte erfolgt mittels sukzessiver Gewinnung der Messwerte für Spannung und Temperatur der jeweiligen Batteriezelle B₁, ..., Bₙ durch das zugehörige Messmodul M₁, ..., Mₙ, geeigneter Bewertung der eigenen Messwerte mit der von einem vorhergehenden Messmodul empfangenen Spannungs- bzw. Temperaturinformation und Weiterleitung der bewerteten Spannungs- bzw. Temperaturinformation zum nächsten Messmodul. Im einzelnen ist dazu folgende Vorgehensweise in den Messmodulen M₁, ..., Mₙ implementiert. Zunächst wird beispielsweise von einer nicht gezeigten Überwachungssteuereinheit ein Triggersignal "Trigger up", wie es im obersten Diagramm von Fig. 2 gezeigt ist, vom letzten Messmodul Mₙ bis zum ersten Messmodul M₁ geleitet, von wo es als Rücksignal "Trigger down" wieder zum letzten Messmodul Mₙ zurückläuft und dabei erst beim Rücklauf den Messvorgang im jeweiligen Messmodul auslöst. Dadurch beginnt in einem Messzyklus das erste Messmodul M₁ mit der Erfassung von Spannung und Temperatur der ersten Batteriezelle B₁. Es leitet diese Information dann sowohl als minimalen wie auch als maximalen Spannungswert bzw. Temperaturwert an das zweite Messmodul M₂ weiter. Das zweite Messmodul M₂ empfängt diese Messgrößeninformation und misst seinerseits Spannung und Temperatur der zweiten Batteriezelle B₂. Anschließend nimmt es eine Bewertung für beide Messgrößen vor, indem es feststellt, ob die selbst gemessene Spannung der zweiten Batteriezelle B₂ kleiner oder größer als der ihm zugeführte Spannungswert für die erste Batteriezelle B₁ ist. Es gibt dann den kleineren Spannungswert als den Spannungsminimalwert Uₘᵢₙ und den größeren Spannungswert als den Spannungsmaximalwert Uₘₐₓ an das dritte Messmodul M₃ weiter. Analog verfährt es mit der Temperatur als der zweiten Messgröße.

Das dritte Messmodul M₃ misst seinerseits Spannung und Temperatur der dritten Batteriezelle B₃ und vergleicht den selbstgemessenen Spannungswert einerseits mit dem ihm zugeführten bisherigen minimalen Spannungswert Uₘᵢₙ und andererseits mit dem ihm zugeführten bisherigen maximalen Spannungswert Uₘₐₓ. Vom erstgenannten Minimalwertvergleich gibt es den kleineren Wert als aktuellen minimalen Spannungswert an das nächste Messmodul weiter, vom letztgenannten Maximalwertvergleich gibt es den größeren Wert als aktuellen maximalen Spannungswert an das nächste Messmodul weiter. Ebenso verfährt es mit der anderen Messgröße, der Temperatur. Auf diese Weise werden die vier Extremalwertinformationen Uₘᵢₙ, Uₘₐₓ, Tₘᵢₙ, Tₘₐₓ vom jeweils vorherigen Messmodul empfangen, mit den eigenen Messwerten entsprechend bewertet und als solchermaßen aktualisierte Messgrößeninformationen zum nächsten Messmodul weitergeleitet, bis schließlich das letzte Messmodul Mₙ die für die Gesamtheit der einzelnen Batteriezellen B₁, ..., Bₙ gültigen Spannungs- und Temperaturextremalwerte Uₘᵢₙ, Uₘₐₓ, Tₘᵢₙ, Tₘₐₓ abgibt, um sie z.B. der Überwachungssteuereinheit zuzuführen.

Indem die Triggerung der Messmodule M₁, ..., Mₙ, wie beschrieben, erst mit dem rücklaufenden Triggersignal "Trigger down" erfolgt und so zuerst das von der Einspeisestelle des Triggersignals, d.h. dem letzten Messmodul Mₙ der Messmodulkette, am weitesten entfernte Messmodul, d.h. das erste Messmodul M₁, getriggert wird, wird eine vorteilhafte Kompensation der Triggersignallaufzeit erreicht, die sich in der zeitlichen Verzögerung des im mittleren Diagramm von Fig. 2 dargestellten, zurückgelaufenen Triggersignals "Trigger down" gegenüber dem eingespeisten Triggersignal "Trigger up" widerspiegelt. Alternativ kann eine solche Kompensation der Triggersignallaufzeit auch dadurch erreicht werden, dass die Messmodule M₁, ..., Mₙ bereits mit dem eingespeisten Triggersignal "Trigger up" aktiviert werden, die Spannungs- und Temperaturmessinformationen dann aber am zuletzt getriggerten Messmodul am der Triggersignaleinspeisestelle gegenüberliegenden Ende der Messmodulkette abgenommen werden.

Eine einfache Extremalwertbewertung der Messsignalinformationen lässt sich bei Verwendung von pulsweitenmodulierten Messsignalen erreichen, deren Pulsweite den zugehörigen Messwert repräsentiert. Dies ist für das Spannungssignal im unteren Diagramm von Fig. 2 veranschaulicht. Dort ist dementsprechend das Spannungsminimalwertsignal mit durchgezogener Linie in einer Pulsbreite Δtₘᵢₙ gezeigt, die den minimalen Spannungswert Uₘᵢₙ repräsentiert. In gleicher Weise ist das Spannungsmaximalwertsignal mit gepunkteter Linie in einer Breite Δtₘₐₓ gezeigt, die den maximalen Spannungswert Uₘₐₓ repräsentiert. Die Minimalwert-Bewertung kann dann im jeweiligen Messmodul durch einfache UND-Verknüpfung des eigenen Messwertes mit dem vom vorigen Messmodul zugeführten, bislang geltenden Minimalwert erfolgen, deren Resultat den neu geltenden Minimalwert darstellt, d.h. es wird das schmalere der beiden verglichenen Signale ausgewählt. In gleicher Weise kann die Maximalwert-Bewertung durch einfache ODER-Verknüpfung des eigenen Messwertes mit dem zugeführten, bislang geltenden Maximalwert realisiert sein, d.h. es wird das jeweils breitere der beiden verglichenen Signale ausgewählt.

Die Messgeschwindigkeit für einen Messzyklus ist bei Verwendung solcher pulsweitenmodulierter Messsignale primär abhängig vom Produkt der maximal auftretenden Pulsbreite mit der Modulanzahl n. Durch die Verwendung von pulsweitenmodulierten Messsignalen lässt sich eine Fehleraddition beim Weiterleiten der Messgrößeninformationen vom einen zum nächsten Messmodul vermeiden, es addieren sich lediglich Laufzeitdifferenzen.

Alternativ zur beschriebenen Verwendung pulsweitenmodulierter Messsignale können die Messwertinformationen auch einfach als analoge Messgrößeninformationen, insbesondere über Extremalwerte der betrachteten Messgrößen, in der Messmodulkette weitergeleitet und bewertet werden. In diesem Fall ist kein Triggersignal nötig, vielmehr kann quasi-parallel gemessen werden, und die Messwertinformationen können seriell bewertet und weitergeleitet werden. Unabhängig von der Konfiguration der Messgrößeninformationen besteht ein allgemeiner Vorteil der seriellen Verknüpfung der Messmodule M₁, ..., Mₙ über die serielle Signalverbindung SV darin, dass die Messmodule M₁, ..., Mₙ nicht spannungsfest ausgelegt sein müssen.

Eine weitere alternative Möglichkeit der Konfiguration der bewerteten und weitergeleiteten Messgrößeninformationen besteht darin, als Messsignal einen Puls mit konstanter Impulsbreite zu verwenden, der zu einem vom zu kodierenden Messwert abhängigen Zeitpunkt erzeugt wird, d.h. um eine vom Messwert abhängige Zeitspanne gegenüber einem Referenzzeitpunkt verzögert. Diese Variante erlaubt die Übertragung sowohl eines Maximalwertes als auch eines Minimalwertes auf einer gemeinsamen Übertragungsleitung ohne codiertes Triggersignal, in dem z.B. der Minimalwert dem frühesten Puls und der Maximalwert dem spätesten Puls entspricht und zwischenliegende Pulse jeweils nicht weitergeleitet werden. Es genügt dann ein jeweiliger ODER-Vergleich zwischen dem eigenen Messsignal mit dem empfangenen frühesten bzw. dem empfangenen spätesten Puls zur Bewertung hinsichtlich Minimalwert und Maximalwert der jeweiligen Messgröße, wie Spannung, Temperatur oder Druck. Es ist lediglich für einen Abgleich der konstanten Pulsbreite zwischen den Messmodulen, M₁, ..., Mₙ zu sorgen.

Soweit die verwendete Messsignalkonfiguration eine Messwertcodierung durch digitale Signale beinhaltet, versteht sich, dass die Messmodule M₁, ..., Mₙ jeweils einen entsprechenden A/D-Wandler enthalten und im Signalauswerteteil der Überwachungseinrichtung eine geeignete herkömmliche digitale Signalverarbeitung implementiert ist.

Zu der in Fig. 1 gezeigten und oben beschriebenen Überwachungseinrichtung sind verschiedene vorteilhafte Modifikationen möglich. So kann z.B. auf dem Triggerleitungspaar TR_{H}, TR_{R} oder einer eigenständigen seriellen Steuersignalverbindung die sukzessive Weiterleitung eines Betriebsmodus-Steuersignals über die Messmodulkette hinweg vorgesehen sein, mit welchem die Messmodule M₁, ..., Mₙ zwischen einem aktivierten Zustand, in welchem sie die beschriebenen Mess- und Bewertungsvorgänge ausführen können, und einem deaktivierten, abgeschalteten Zustand umschaltbar sind, in welchem sie keinen oder einen allenfalls sehr geringen Ruhestrom verbrauchen, so dass insgesamt der Stromverbrauch minimiert wird. Bevorzugt wird dabei jedes Messmodul M₁, ..., Mₙ von der zugehörigen Batteriezelle B₁, ..., Bₙ versorgt.

In einer weiteren Variante kann die Weiterleitung eines Bewertungsmodus-Steuersignals vorgesehen sein, mit welchem die Messmodule M₁, ..., Mₙ zwischen verschiedenen Bewertungsmodi umgeschaltet werden können, beispielsweise zwischen einer Bewertung auf maximale Spannung während Ladevorgängen und einer Bewertung auf minimale Spannung während Entladevorgängen oder abwechselnd zwischen einer Druck- und einer Temperaturbewertung oder zwischen beliebigen anderen möglichen Bewertungsarten. Es genügt dann gegebenenfalls eine einzige Messsignalleitung, über welche die zum jeweils aktiven Bewertungsmodus gehörige Messgrößeninformation übertragen wird. Als weitere Modifikation kann die Durchleitung eines Selektions-Steuersignals durch die Messmodulkette hindurch vorgesehen sein, mit welchem die dazu entsprechend ausgelegten Messmodule M₁, ..., Mₙ zwischen einem aktiv bewertenden Zustand und einem passiv bleibenden, bloß weiterleitenden Zustand umgeschaltet werden können. Auf diese Weise kann aus der Messmodulkette eine beliebige Teilmenge von Messmodulen ausgewählt werden, deren Messwerte zur Gewinnung der entsprechenden Messgrößeninformation herangezogen werden, während die übrigen Messmodule lediglich die empfangene Messgrößeninformation unverändert weiterleiten. Dadurch können z.B. Minimalwerte und/oder Maximalwerte einer Messgröße für eine beliebige Teilmenge der Batteriezellen B₁, ..., Bₙ bestimmt werden.

In einer zum Überwachungstyp von Fig. 1 alternativen Realisierung der Erfindung gemäß Fig. 3 ist statt der seriellen Signalverbindung SV eine parallele Ankopplung der Messmodule M₁, ..., Mₙ an eine gemeinsame Signalverbindung SV' aus einer oder mehreren Signalleitungen vorgesehen. Bevorzugt ist die Anbindung der Messmodule M₁, ..., Mₙ an die gemeinsame Signalleitung SV' über eine Kapazität C, wie gezeigt, oder eine Induktivität und somit galvanisch entkoppelt realisiert. Bei dieser Ausführungsform werden die Messgrößeninformationen und gegebenenfalls die Trigger- und/oder Steuersignale nicht von einem zum nächsten Messmodul weitergereicht, sondern von diesen parallel auf die gemeinsame Signalverbindung SV gelegt. Dies kann für die codierte Messgrößeninformation z.B. als Spannungssprung erfolgen, der vom jeweiligen Messmodul auf die gemeinsame Signalleitung gelegt wird. Eine weitere möglich Signalkonditionierung besteht darin, das Messsignal als Konstantstromsignal auf die gemeinsame zugehörige Signalleitung zu legen, die als Summenleitung fungieren kann, indem sie mit einem Widerstand gegen einen Pol der Batterie B abgeschlossen wird, wobei dann die Stromstärke den Messwert repräsentiert.

Die Variante mit gemeinsamer, paralleler Signalverbindung der Messmodule M₁, ..., Mₙ eignet sich insbesondere gut zur Ermittlung des Minimalwertes und des Maximalwertes einer jeweiligen Messgröße, ohne dass hierzu eine UND- bzw. ODER-Bewertung in den einzelnen Messmodulen erforderlich ist. Wenn beispielsweise eine Messsignalcodierung als pulsbreitenmoduliertes Signal verwendet wird, ergibt sich der Maximalwert einfach aus der Pulsbreite des Gesamtsignals auf der gemeinsamen Signalleitung, auf das die Messmodule M₁, ..., Mₙ ihre pulsweitenmodulierten Signale geben. Die Messmodule M₁, ..., Mₙ lassen sich bei diesem Systemtyp ohne Laufzeitfehler gleichzeitig triggern. Die für eine galvanische Entkopplung verwendete Kapazität kann gegebenenfalls schon durch eine Leiterbahn realisiert sein. Im übrigen gelten für diesen Systemtyp mit gemeinsamer Signalverbindung die entsprechenden Eigenschaften und Vorteile, wie sie oben zum Systemtyp von Fig. 1 mit serieller Signalverbindung angegeben sind.

Die auf die eine oder andere der oben erläuterten Arten gewonnenen Messgrößeninformationen können dann in geeigneter Weise verwertet werden, insbesondere dazu, unerwünschte Zustände einzelner Batteriezellen zu erkennen und geeignete Gegenmaßnahmen zu ergreifen. Eine solche Maßnahme ist die Durchführung einer dissipativen Ladungsangleichung, d.h. zu unterschiedliche Ladezustände zwischen einzelnen Batteriezellen werden dadurch vermieden, dass Zellen mit zu hohem Ladezustand über einen elektrischen Widerstand ausreichend entladen werden. Dazu beinhaltet jedes Messmodul M₁, ..., Mₙ den entsprechenden Widerstand R, der zum Entladen der betreffenden Batteriezelle steuerbar parallel an diese angekoppelt werden kann, und eine zugehörige Endladesteuerschaltung 2. Sein Widerstandswert bestimmt sich primär aus der Differenz der Selbstentladungseigenschaften aller Batteriezellen B₁, ..., Bₙ und der Zeitdauer, innerhalb der ein maximaler Ladezustandsunterschied ausgeglichen werden soll. Eine untere Begrenzung des Widerstandswerts ist eventuell durch eine maximal erlaubte Erwärmung vor Ort gegeben. Der Verlust durch die dissipative Entladung trägt in Anwendungen mit hohem Ladungsdurchsatz bei Batterien mit kleiner Kapazität nur unwesentlich zu den üblichen, anderweitigen Verlusten bei und ist daher tolerierbar.

Damit das jeweilige Messmodul weiß, ob es seine zugehörige Batteriezelle entladen muss oder nicht, wird die zuvor ermittelte Information über den minimalen Spannungswert Uₘᵢₙ allen Messmodulen M₁, ..., Mₙ zur Verfügung gestellt, im Beispiel von Fig. 1 dadurch, dass sie vom letzten Messmodul Mₙ sukzessive an die übrigen Messmodule bis zum ersten Messmodul M₁ weitergeleitet wird. Jedes Messmodul M₁, ..., Mₙ vergleicht dann den minimalen Spannungswert Uₘᵢₙ mit dem eigenen gemessenen Spannungswert der zugeordneten Batteriezelle B₁, ..., Bₙ und aktiviert den dissipativen Entladevorgang, wenn der eigene Spannungswert um mehr als ein vorgegebener Abstand über dem minimalen Spannungswert Uₘᵢₙ liegt. Zur seriellen Übertragung des minimalen Spannungswertes Uₘᵢₙ kann in einer vorteilhaften Realisierung der ohnehin benötigte Triggerimpuls bzw. die Triggersignalverbindung TR_{H}, TR_{R} dienen. Als übertragenes Signal kann dem minimalen Spannungswert gleich der vorgebbare Abstandswert hinzuaddiert werden, der das Toleranzband repräsentiert, in welchem alle Zellenladezustände liegen sollen, so dass jedes Messmodul M₁, ..., Mₙ nur noch den eigenen Spannungsmesswert mit dem über die Triggerleitung TR_{H}, TR_{R} übermittelten minimalen Spannungswert Uₘᵢₙ vergleichen muss, um zu entscheiden, ob es eine dissipative Entladung seiner Zelle vornimmt.

Wenngleich die Erfindung oben anhand einer Batterie B erläutert wurde, versteht es sich, dass sie sich auch für andere herkömmliche elektrische Energiespeicher bzw. Energieerzeuger eignet, z.B. für einen Brennstoffzellenstapel eines Brennstoffzellensystems, das stationär oder mobil, z.B. in einem Brennstoffzellenfahrzeug, angeordnet sein kann.

## Patentansprüche

1. Elektronische Überwachungseinrichtung für einen aus mehreren hintereinandergeschalteten Speichereinheiten (B₁, ..., Bₙ) bestehenden elektrischen Energiespeicher (B), mit
- den Speichereinheiten jeweils zugeordneten Messmodulen (M₁, ..., Mₙ), die wenigstens eine speicherzustandsindikative Messgröße an der zugeordneten Speichereinheit messen und die parallel an eine gemeinsame Signalverbindung (SV') angeschlossen sind,
**dadurch gekennzeichnet, dass**
- die Messmodule (M₁, ..., Mₙ) darauf ausgelegt sind, ihre erfassten Messgrößenwerte parallel in einer hinsichtlich Extremalwertbildung aus den Messgrößenwerten auf der gemeinsamen Signalverbindung codierten Form zu übertragen und dass die Messmodule (M₁, ..., Mₙ) ihre Meßgrößeninformationen dergestalt konditionieren und parallel auf die Signalleitung geben, dass die dadurch auf dieser gebildete Gesamt-Messgrößeninformation eine auswertbare, zugehörige Extremalwert-Messgrößeninformation enthält.

2. Elektronische Überwachungseinrichtung nach Anspruch 1, weiter
**dadurch gekennzeichnet, dass**
die Messmodule (M₁, ..., Mₙ) über eine Kapazität (C) oder eine Induktivität an die gemeinsame Signalverbindung (SV') angekoppelt sind.

3. Elektronische Überwachungseinrichtung nach einem der Ansprüche 1 oder 2, weiter
**dadurch gekennzeichnet, dass**
Mittel zum Umschalten der Messmodule (M₁, ..., Mₙ) zwischen einem aktivierten und einem deaktivierten Zustand durch ein Betriebsmodus-Steuersignal vorgesehen sind.

4. Elektronische Überwachungseinrichtung nach einem der Ansprüche 1, 2 oder 3, weiter
**dadurch gekennzeichnet, dass**
Mittel zur Umschaltung der Messmodule (M₁, ..., Mₙ) zwischen verschiedenen Bewertungsmodi durch ein Bewertungsmodus-Steuersignal vorgesehen sind.

5. Elektronische Überwachungseinrichtung nach einem der Ansprüche 1 bis 4, weiter
**dadurch gekennzeichnet, dass**
Mittel zur selektiven Steuerung der Messmodule (M₁, ..., Mₙ) in einen voll aktiven oder in einen passiven, signalweiterleitenden Betriebszustand vorgesehen sind.

6. Elektronische Überwachungseinrichtung nach einem der Ansprüche 1 bis 5, weiter
**dadurch gekennzeichnet, dass**
die Messmodule (M₁, ..., Mₙ) zur Codierung der Messwerte in pulsweitenmodulierte Messsignale eingerichtet sind.

7. Elektronische Überwachungseinrichtung nach einem der Ansprüche 1 bis 5, weiter
**dadurch gekennzeichnet, dass**
die Messmodule (M₁, ..., Mₙ) zur Codierung der Messwerte in Pulssignale mit vom Messwert abhängiger Pulsverzögerung eingerichtet sind.

8. Elektronische Überwachungseinrichtung nach einem der Ansprüche 1 bis 5, weiter
**dadurch gekennzeichnet, dass**
die Messmodule (M₁, ..., Mₙ) zur Codierung der Messwerte in Konstantstrom-Messsignale mit messwertabhängiger Stromstärke eingerichtet sind.

9. Elektronische Überwachungseinrichtung nach einem der Ansprüche 1 bis 8, weiter
**dadurch gekennzeichnet, dass**
jedes Messmodul (M₁, ..., Mₙ) einen elektrischen Widerstand sowie Entlademittel zur steuerbaren, entladenden Ankopplung des Widerstands an die zugeordnete Speichereinheit aufweist.

## Claims

1. Electronic monitoring device for an electric energy storage device (B) comprising a plurality of storage units (B₁ ..... Bₙ) connected in series, with
- measuring modules (M₁ ..... Mₙ) assigned to each storage unit, which measure at least one variable indicative of the storage state at the associated storage unit and which are connected in parallel to a common signal connection (SV'),
**characterised in that**
- the measuring modules (M₁ ..... Mₙ) are designed to transmit the detected measured variables in parallel in a coded form on the common signal connection with regard to the formation of extremum values from the measured variables, and **in that** the measuring modules (M₁ ..... Mₙ) condition their measured variable information and place it on the signal line such that the resulting overall measured variable information contains an evaluable associated extremum value measured variable information.

2. Electronic monitoring device according to claim 1, further
**characterised in that** the measuring modules (M₁ ..... Mₙ) are connected to the common signal connection (SV') via a capacitor (C) or an inductance coil.

3. Electronic monitoring device according to any of claims 1 or 2, further
**characterised in that** means are provided for switching the measuring modules (M₁ ..... Mₙ) between an activated and a deactivated state by means of an operating mode control signal.

4. Electronic monitoring device according to any of claims 1, 2 or 3, further
**characterised in that** means are provided for switching the measuring modules (M₁ ..... Mₙ) between various evaluation modes by means of an evaluation mode control signal.

5. Electronic monitoring device according to any of claims 1 to 4, further
**characterised in that** means are provided for the selective steering of the measuring modules (M₁ ..... Mₙ) into a fully active operating mode or a passive, signal-conducting operating mode.

6. Electronic monitoring device according to any of claims 1 to 5, further
**characterised in that** the measuring modules (M₁ ..... Mₙ) are set up for encoding the measured values to provide pulse width modulated measuring signals.

7. Electronic monitoring device according to any of claims 1 to 5, further
**characterised in that** the measuring modules (M₁ ..... Mₙ) are set up for encoding the measured values to provide pulse signals with a pulse delay dependent on the measured value.

8. Electronic monitoring device according to any of claims 1 to 5, further
**characterised in that** the measuring modules (M₁ ..... Mₙ) are set up for encoding the measured values to provide constant current measuring signals with an amperage dependent on the measured value.

9. Electronic monitoring device according to any of claims 1 to 8, further
**characterised in that** the measuring modules (M₁ ..... Mₙ) comprise a resistor and discharge means for the controllable, discharged coupling of the resistor to the associated storage unit.

## Revendications

1. Appareil électronique de surveillance pour un accumulateur d'énergie électrique (B) constitué de plusieurs parties d'accumulateur connectées les unes derrière les autres (B₁, ..., Bₙ), avec des modules de mesure correspondant à chaque partie d'accumulateur (M₁, ..., Mₙ), qui mesurent au moins une grandeur de mesure indicative de l'état de l'accumulateur au niveau de la partie d'accumulateur correspondante et qui sont raccordés en parallèle à une connexion de signal (SV'), **caractérisé en ce que** les modules de mesure (M₁, ..., Mₙ) sont conçus pour transmettre en parallèle leurs valeurs de grandeur de mesure saisies sous une forme codée relativement à la formation de valeurs extrémales provenant des valeurs de grandeurs de mesure sur l'ensemble de la connexion de signal, et **en ce que** les modules de mesure (M₁, ..., Mₙ) conditionnent à tel point leurs informations relatives aux grandeurs de mesure et les donnent en parallèle au circuit d'acheminement des signaux que l'information relative à la grandeur de mesure totale ainsi formée sur celui-ci contienne une information relative à la grandeur de mesure de valeur extrémale adéquate et exploitable.

2. Appareil électronique de surveillance selon la revendication 1, **caractérisé en outre en ce que** les modules de mesure (M₁, ..., Mₙ) sont couplés par une capacité (C) ou une inductance à la connexion de signal commune (SV').

3. Appareil électronique de surveillance selon l'une des revendications 1 ou 2, **caractérisé en outre en ce que** des moyens sont prévus pour commuter les modules de mesure (M₁, ... Mₙ) entre un état activé et un état désactivé grâce à un signal de commande du mode opérationnel.

4. Appareil électronique de surveillance selon l'une des revendications 1, 2 ou 3, **caractérisé en outre en ce que** des moyens sont prévus pour commuter les modules de mesure (M₁, ..., Mₙ) entre différents modes d'évaluation grâce à un signal de commande du mode d'évaluation.

5. Appareil électronique de surveillance selon l'une des revendications 1 à 4, **caractérisé en outre en ce que** des moyens sont prévus pour commander sélectivement les modules de mesure (M₁, ..., Mₙ) en un état opérationnel entièrement actif ou bien passif transmettant les signaux.

6. Appareil électronique de surveillance selon l'une des revendications 1 à 5, **caractérisé en outre en ce que** les modules de mesure (M₁, ..., Mₙ) sont installés pour coder les valeurs de mesure en des signaux de mesure à modulation d'impulsions en largeur.

7. Appareil électronique de surveillance selon l'une des revendications 1 à 5, **caractérisé en outre en ce que** les modules de mesure (M₁, ..., Mₙ) sont installés pour coder les valeurs de mesure en des signaux d'impulsion avec temporisation des impulsions dépendants de la valeur de mesure.

8. Appareil électronique de surveillance selon l'une des revendications 1 à 5, **caractérisé en outre en ce que** les modules de mesure (M₁, ..., Mₙ) sont installés pour coder les valeurs de mesure en des signaux de mesure de courant constant avec des intensités de courant dépendant des valeurs de mesure.

9. Appareil électronique de surveillance selon l'une des revendications 1 à 8, **caractérisé en outre en ce que** chaque module de mesure (M₁, ..., Mₙ) présente une résistance électrique ainsi qu'un moyen de décharge pour le couplage pouvant être commandé et déchargé de la résistance à la partie d'accumulateur correspondante.
